(19) Europäisches Patentamt
European Patent Office
Office européen des brevets

(11) **EP 3 264 116 B1**

(12) **FASCICULE DE BREVET EUROPEEN**

(45) Date de publication et mention
de la délivrance du brevet:
**24.03.2021  Bulletin 2021/12**

(51) Int Cl.:
**G01R 31/12** *(2020.01)*        **G01R 23/17** *(2006.01)*
**H02H 1/00** *(2006.01)*

(21) Numéro de dépôt: **17174376.8**

(22) Date de dépôt: **02.06.2017**

(54) **DISPOSITIF DE DÉTECTION D'UN ARC ÉLECTRIQUE À PARTIR DE SA SIGNATURE ACOUSTIQUE**

VORRICHTUNG ZUR DETEKTION EINES LICHTBOGENS DURCH SEINE AKUSTISCHE SIGNATUR

DEVICE FOR DETECTING AN ELECTRIC ARC FROM THE ACOUSTIC SIGNATURE THEREOF

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **27.06.2016  FR 1655981**

(43) Date de publication de la demande:
**03.01.2018  Bulletin 2018/01**

(73) Titulaire: **Commissariat à l'Energie Atomique et aux Energies Alternatives
75015 Paris (FR)**

(72) Inventeurs:
• **ALBERTO, Diego
  38600 FONTAINE (FR)**
• **RANIERI, Marco
  38610 GIERES (FR)**
• **TOUFFLET, Raphaël
  38000 GRENOBLE (FR)**

(74) Mandataire: **Cabinet Beaumont
4, Place Robert Schuman
B.P. 1529
38025 Grenoble Cedex 1 (FR)**

(56) Documents cités:
WO-A1-2013/150157        CN-U- 204 441 661
FR-A1- 3 015 045         US-A1- 2006 164 097

**Description**

Domaine

La présente demande concerne un dispositif pour détecter la formation d'un arc électrique dans un système électrique à partir de sa signature acoustique.

Exposé de l'art antérieur

Dans de nombreux systèmes électriques, notamment des systèmes haute tension tels que des armoires électriques, des transformateurs, des batteries électriques, des réseaux de distribution électrique, etc., des arcs électriques peuvent se former, par exemple par suite d'une surtension ou d'une défaillance telle que la rupture d'un câble ou l'usure d'un isolant. S'il est entretenu, un arc électrique peut provoquer de graves dommages et notamment entrainer un départ de feu. Les arcs électriques sont tout particulièrement dangereux dans les systèmes électriques à alimentation continue, dans la mesure où l'on ne peut pas compter sur un passage à zéro "naturel" de la tension d'alimentation pour provoquer l'extinction de l'arc. La détection précoce de la formation d'un arc électrique est un enjeu majeur pour la sécurité de nombreux systèmes électriques.

Diverses solutions ont été proposées pour détecter la formation d'un arc électrique dans un système électrique. On a notamment proposé des méthodes de détection basées sur des mesures de courant et de tension dans le système, des méthodes de détection basées sur des mesures de signaux optiques, des méthodes de détection basées sur des mesures de signaux électromagnétiques, et des méthodes de détection basées sur des mesures de signaux acoustiques.

On s'intéresse ici plus particulièrement aux méthodes de détection basées sur des mesures de signaux acoustiques.

Le document FR3015045 décrit un exemple d'un procédé de détection d'un arc électrique au moyen d'une mesure d'un niveau acoustique, et le document US2006/164097 décrit un appareil électrique de commutation et une méthode de détection de défaut utilisant une signature acoustique.

Résumé

Ainsi, un mode de réalisation prévoit un dispositif de détection d'un arc électrique à partir d'un signal analogique de sortie d'au moins un capteur d'ondes acoustiques, ce dispositif comprenant : un convertisseur analogique-numérique adapté à échantillonner et numériser le signal de sortie du capteur ; un circuit de traitement numérique adapté à mettre en oeuvre une analyse fréquentielle du signal numérique de sortie du convertisseur permettant de détecter la présence éventuelle d'un arc à partir de sa signature acoustique ; et un circuit analogique de détection d'un dépassement d'un seuil de puissance par le signal de sortie du capteur, dans lequel le circuit de traitement numérique est configuré pour mettre en oeuvre l'analyse fréquentielle uniquement suite à la détection d'un dépassement du seuil par le circuit analogique.

Selon un mode de réalisation, le circuit analogique de détection comprend un circuit analogique de comparaison d'une grandeur représentative de l'amplitude du signal analogique de sortie du capteur à un seuil prédéterminé.

Selon un mode de réalisation, le circuit analogique de détection comprend en outre un circuit analogique de redressement du signal analogique de sortie du capteur, en amont du circuit de comparaison.

Selon un mode de réalisation, le circuit de redressement comprend un pont de diodes.

Selon un mode de réalisation, le circuit de redressement est un circuit actif comprenant au moins un amplificateur opérationnel et au moins deux interrupteurs commandés.

Selon un mode de réalisation, le circuit analogique de détection comprend en outre un circuit analogique de détection d'enveloppe en amont du circuit de comparaison.

Selon un mode de réalisation, le convertisseur analogique-numérique est adapté à numériser en permanence, c'est-à-dire même en l'absence de déclenchement de l'analyse fréquentielle par le circuit analogique de détection, le signal de sortie du capteur.

Selon un mode de réalisation, le dispositif de traitement numérique est adapté à mémoriser en permanence, c'est-à-dire même en l'absence de déclenchement de l'analyse fréquentielle par le circuit analogique de détection, une pluralité d'échantillons du signal de sortie du convertisseur analogique-numérique.

Selon un mode de réalisation, l'analyse fréquentielle comprend le calcul de la densité spectrale de puissance du signal de sortie du convertisseur.

Selon un mode de réalisation, l'analyse fréquentielle comprend en outre le calcul d'une grandeur représentative de l'énergie du signal de sortie du convertisseur dans une bande spectrale caractéristique des arcs électriques, et la détection du franchissement éventuel d'un seuil d'énergie dans cette bande.

Selon un mode de réalisation, la grandeur représentative de l'énergie du signal de sortie du convertisseur dans une bande spectrale caractéristique des arcs électriques est normalisée par rapport à une grandeur représentative de l'énergie du signal de sortie du convertisseur dans une autre bande spectrale.

Brève description des dessins

Ces caractéristiques et leurs avantages, ainsi que d'autres, seront exposés en détail dans la description suivante de modes de réalisation particuliers faite à titre non limitatif en relation avec les figures jointes parmi lesquelles :

la figure 1 illustre un système électrique muni d'un dispositif de détection d'un arc électrique selon un exemple d'un mode de réalisation ;
la figure 2 illustre schématiquement, sous forme de blocs, un exemple d'un circuit analogique de détection d'un seuil de puissance acoustique du dispositif de la figure 1 ;
la figure 3 est un schéma électrique d'un exemple de réalisation d'un circuit de redressement de tension du circuit analogique de la figure 2 ;
la figure 4 est un schéma électrique d'un autre exemple de réalisation d'un circuit de redressement de tension du circuit analogique de la figure 2 ;
la figure 5 est un schéma électrique d'un exemple de réalisation d'un circuit de détection d'enveloppe du circuit analogique de la figure 2 ; et
la figure 6 est un schéma électrique d'un exemple de réalisation du circuit analogique de la figure 2, qui se base à la fois sur un circuit redresseur du type décrit en relation avec la figure 3 et sur un circuit de détection d'enveloppe du type décrit en relation avec la figure 5.

Description détaillée

De mêmes éléments ont été désignés par de mêmes références aux différentes figures. Par souci de clarté, seuls les éléments qui sont utiles à la compréhension des modes de réalisation décrits ont été représentés et sont détaillés. En particulier, les systèmes électriques dans lesquels on cherche à détecter des arcs électriques n'ont pas été détaillés, les solutions de détection décrites étant compatibles avec tous les systèmes électriques dans lesquels peuvent se produire des arcs électriques. Sauf précision contraire, les expressions "approximativement", "sensiblement", et "de l'ordre de" signifient à 10 % près, de préférence à 5 % près. Dans la présente description, on utilise le terme "connecté" pour désigner une liaison électrique directe, sans composant électronique intermédiaire, par exemple au moyen d'une ou plusieurs pistes conductrices ou fils conducteurs, et le terme "couplé" ou le terme "relié", pour désigner une liaison électrique qui peut être directe (signifiant alors "connecté") ou indirecte (c'est-à-dire via un ou plusieurs composants intermédiaires).

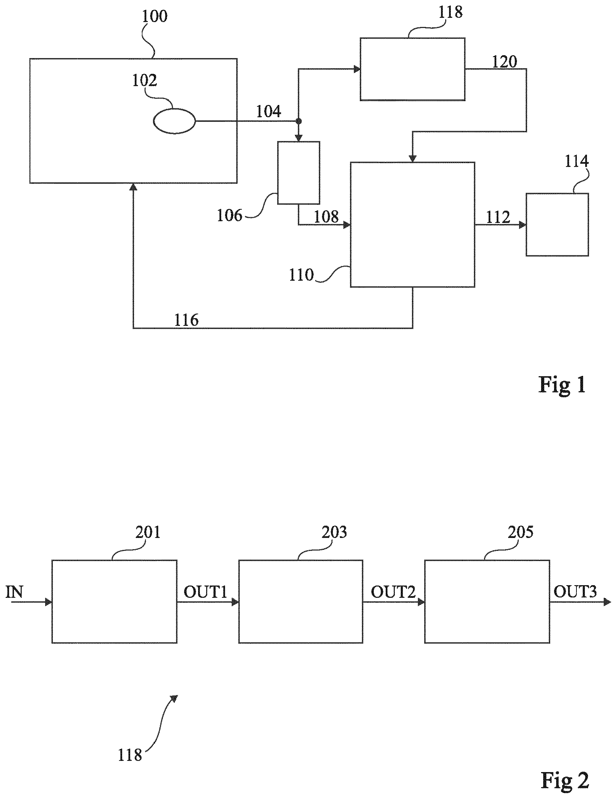

La figure 1 représente un système électrique 100 à surveiller, par exemple une armoire électrique, un réseau de distribution d'électricité dans un avion, une batterie électrique, ou tout autre système électrique dans lequel on souhaite pouvoir détecter l'apparition éventuelle d'un arc électrique.

Le système 100 est équipé d'un dispositif de détection d'un arc électrique comportant un capteur acoustique 102, par exemple un capteur à ultrasons, adapté à détecter des ondes acoustiques dans le système 100. La formation d'un arc électrique s'accompagne en effet de l'émission d'ondes acoustiques caractéristiques dont la détection peut permettre d'identifier la présence de l'arc. Le capteur 102 peut être disposé en contact physique avec un conducteur électrique que l'on souhaite surveiller tout particulièrement, de façon à capter les ondes acoustiques se propageant dans ce conducteur. A titre de variante, le capteur 102 peut être agencé de façon à capter les ondes acoustiques se propageant dans l'air dans ou au voisinage de l'installation. Le capteur 102 est par exemple un microphone à membrane vibrante, par exemple un microphone de type MEMS (de l'anglais "Micro Electro Mechanical System" - micro système électro mécanique). Le capteur 102 est adapté à fournir un signal électrique de sortie 104, par exemple une tension, représentatif de l'amplitude des ondes acoustiques détectées par le capteur. Le signal de sortie 104 du capteur 102 est un signal analogique à temps continu, c'est-à-dire non échantillonné. En pratique, le signal de sortie 104 du capteur 102 peut être pré-traité par des circuits analogiques d'amplification et/ou de filtrage (non détaillés) du capteur 102. Bien qu'un seul capteur 102 soit illustré en figure 1, dans des variantes de réalisation, plusieurs capteurs 102 peuvent être prévus pour surveiller différentes parties du système 100. Les sorties des différents capteurs 102 peuvent alors être traitées séparément de façon similaire ou identique à ce qui va être décrit plus en détail ci-après.

Le dispositif de détection d'arc comprend en outre un circuit de conversion analogique numérique 106 dont l'entrée est reliée à la sortie du capteur 102. Le circuit 106 est adapté à fournir un signal numérique échantillonné 108 représentatif du signal analogique de sortie 104 du capteur 102. Le signal de sortie 108 du convertisseur analogique numérique 106 est un signal dans le domaine temporel, représentant l'évolution en fonction du temps de l'amplitude des ondes acoustiques détectées par le capteur 102.

Le dispositif de détection d'arc comprend de plus un circuit de traitement numérique 110, comportant par exemple un microprocesseur, dont une entrée est reliée à la sortie du convertisseur analogique numérique 106. Le dispositif de calcul 110 est adapté à analyser le signal de sortie 108 du convertisseur analogique numérique 106 pour détecter la présence éventuelle d'un arc électrique dans le système 100. Le circuit de traitement 110 fournit par exemple un signal de sortie 112 à un module de sortie 114 du dispositif de détection d'un arc électrique, qui peut être une alarme, un afficheur, ou tout autre élément d'interface permettant d'informer un utilisateur de la présence d'un arc dans le système 100. Le circuit de traitement 110 peut fournir, en plus ou à la place du signal de sortie 112, un signal de sortie 116 renvoyé vers le système 100, qui peut par exemple commander la mise en sécurité du système 100 lorsqu'un arc électrique est détecté, par exemple par interruption du courant d'alimentation dans tout ou partie du système 100.

La mise en oeuvre d'une détection robuste d'un arc électrique à partir de sa signature acoustique passe par une analyse fréquentielle des signaux acoustiques détectés par le capteur 102. En effet, la détection de pics d'énergie acoustique dans des bandes de fréquences particulières, par exemple entre 80 et 120 kHz dans le cas d'ondes se propageant dans des conducteurs électriques de l'installation, ou entre 65 et 90 kHz dans le cas d'ondes se propageant dans l'air, permet d'obtenir de bonnes performances de détection des arcs électriques et de minimiser les risques de fausse détection liés à d'autres phénomènes susceptibles de générer des signaux acoustiques, par exemple des chocs mécaniques. La relation entre la bande de fréquences étudiée et le phénomène associé dépend de plusieurs paramètres parmi lesquels on trouve la fonction de transfert du capteur, les caractéristiques physiques du moyen de transmission, la température, la pression atmosphérique, etc. L'analyse fréquentielle en temps réel du signal de sortie 108 du convertisseur numérique analogique 106 requiert toutefois des ressources calculatoires importantes, et se traduit par une consommation électrique élevée du circuit de traitement 110.

Selon un aspect d'un mode de réalisation, le dispositif de détection d'arc comprend un circuit analogique 118 connecté à la sortie du capteur 102 et adapté à détecter un dépassement d'un seuil de puissance prédéterminé par le signal analogique de sortie 104 du capteur 102. Le circuit 118 fournit un signal de sortie 120, par exemple un signal binaire, dont l'état change lorsqu'une grandeur représentative du niveau de puissance ou d'amplitude du signal de sortie 104 du capteur 102 dépasse un seuil prédéterminé. La sortie du circuit analogique 118 est reliée au circuit de traitement 110. Le circuit 110 est configuré pour mettre en oeuvre une analyse fréquentielle du signal de sortie 108 du convertisseur analogique numérique 106 en vue de détecter la présence éventuelle d'un arc, uniquement lorsque le circuit 118 détecte un dépassement d'un seuil de puissance ou d'amplitude par le signal de sortie 104 du capteur 102. Autrement dit, le circuit analogique 118 met en oeuvre une surveillance continue du système 100, permettant de détecter au plus vite la formation d'un arc électrique, mais ne déclenche l'analyse fréquentielle que lorsqu'un évènement acoustique de puissance significative est détecté, pour permettre de discriminer un arc électrique parmi différents types d'événements susceptibles de produire des ondes acoustiques de puissance significative.

Un avantage du mode de réalisation de la figure 1 est que, en l'absence d'événement acoustique remarquable détecté par le circuit analogique 118, le circuit de traitement numérique 110 n'effectue pas l'analyse fréquentielle, lourde en calculs, du signal numérique 108. Ceci permet de limiter la consommation électrique globale du dispositif de détection d'arc.

Un autre avantage est que la détection d'événement acoustique remarquable utilisée pour décider de déclencher ou non l'analyse fréquentielle est réalisée dans le domaine analogique, avant échantillonnage du signal de sortie du capteur 102. Ceci permet de garantir une détection rapide de tout évènement produisant des ondes acoustiques de puissance significative, et donc de détecter au plus tôt la formation d'un arc.

De préférence, le convertisseur analogique numérique 106 numérise en permanence, c'est-à-dire même en l'absence d'événement acoustique remarquable, le signal analogique de sortie 104 du capteur 102, et le circuit de traitement 110 mémorise en permanence, par exemple dans une mémoire de type FIFO, un nombre déterminé p, par exemple compris entre 200 et 2000, d'échantillons du signal numérique de sortie 108 du convertisseur 106. Ceci permet au dispositif 110, lorsque l'analyse fréquentielle est déclenchée par le circuit 118, de pouvoir disposer d'échantillons du signal acoustique précédant le début de la formation de l'arc. Ceci améliore les performances de détection dans la mesure où les composantes fréquentielles les plus caractéristiques d'un arc se situent souvent au début de l'arc. Les modes de réalisation décrits ne se limitent toutefois pas à ce cas particulier.

La figure 2 illustre schématiquement, sous forme de blocs, un exemple de réalisation du circuit analogique 118 du dispositif de détection d'arc de la figure 1.

Dans l'exemple de la figure 2, le circuit 118 comprend un circuit de redressement 201, recevant en entrée un signal analogique IN, correspondant au signal de sortie 104 du capteur 102 de la figure 1, et fournissant en sortie un signal analogique redressé OUT1.

Le circuit 118 de la figure 2 comprend en outre un circuit de détection d'enveloppe 203 recevant en entrée le signal OUT1 de sortie du circuit de redressement 201, et fournissant en sortie un signal analogique OUT2 représentatif de l'enveloppe du signal OUT1.

Le circuit 118 de la figure 2 comprend de plus un circuit 205 de comparaison du signal OUT2 à un seuil. Le circuit 205 fournit un signal de sortie OUT3, par exemple un signal binaire, représentatif du résultat de la comparaison. Le signal de sortie OUT3 du comparateur 205 correspond au signal de sortie 120 du circuit 118, et est utilisé pour déclencher la mise en oeuvre de l'analyse fréquentielle du signal acoustique par le circuit de traitement numérique 110 de la figure 1. Le comparateur 205 est de préférence un comparateur à hystérésis pour éviter des oscillations indésirables du signal OUT3.

On notera que les circuits 201 et/ou 203 de l'exemple de la figure 2 sont optionnels. A titre de variante, les circuits 201 et 203 peuvent être omis, et le comparateur 205 peut recevoir en entrée directement le signal d'entrée IN. Dans une autre variante, le circuit 203 peut être omis, et le comparateur 205 peut recevoir en entrée directement le signal de sortie OUT1 du circuit de redressement 201. Dans une autre variante, le circuit 201 peut être omis, le circuit 203 fournissant alors au comparateur 205 un signal OUT2 représentatif de l'enveloppe du signal IN.

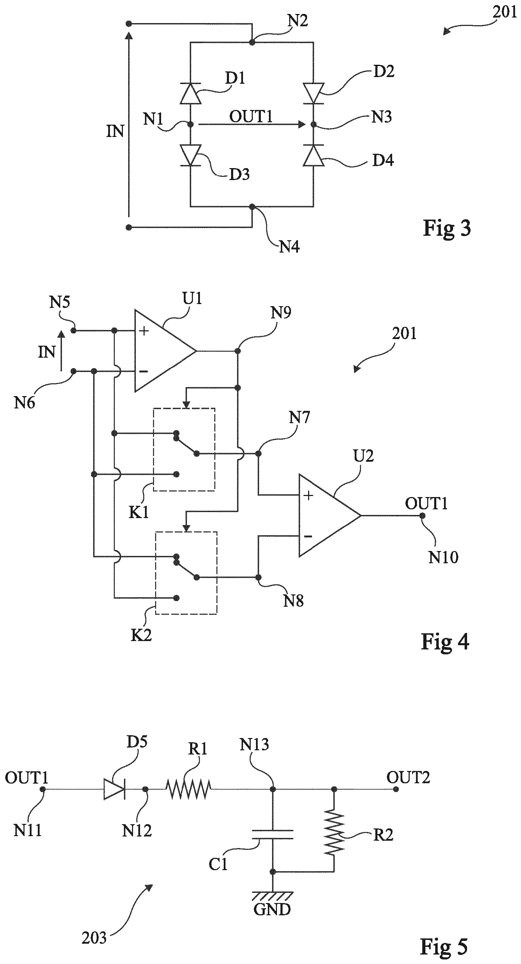

La figure 3 est un schéma électrique d'un exemple de réalisation du circuit de redressement 201 de la figure 2. Dans cet exemple, on considère que les signaux IN et OUT1 sont des tensions. Le circuit de redressement 201 de la figure 3 est un pont redresseur double alternance comportant quatre diodes D1, D2, D3, D4. La diode D1 est connectée en direct entre des noeuds N1 et N2 du circuit 201, c'est-à-dire que l'anode et la cathode de la diode D1 sont connectées respectivement au noeud N1 et au noeud N2. La diode D2 est connectée en direct entre le noeud N2 et un noeud N3 du circuit 201. La diode D3 est connectée en direct entre le noeud N1 et un noeud N4 du circuit 201. La diode D4 est connectée en direct entre le noeud N4 et le noeud N3. La tension d'entrée IN du circuit de redressement 201 est appliquée entre les noeuds N2 et N4, et la tension de sortie redressée OUT1 est fournie entre les noeuds N3 et N1.

La figure 4 est un schéma électrique d'un autre exemple de réalisation du circuit de redressement 201 de la figure 2. Par rapport au circuit de la figure 3, le circuit de la figure 4 présente l'avantage d'éviter la chute de tension introduite par les diodes D1, D2, D3, D4 du circuit de la figure 3 entre le signal d'entrée IN et le signal de sortie OUT1 du circuit. Le circuit 201 de la figure 4 comprend un premier amplificateur opérationnel U1 monté en comparateur, dont l'entrée positive (+) est reliée à un premier noeud N5 d'application de la tension d'entrée IN et dont l'entrée négative (-) est reliée à un deuxième noeud N6 d'application de la tension d'entrée IN (c'est-à-dire que la tension IN est appliquée entre les noeuds N5 et N6). Le circuit 201 de la figure 4 comprend en outre un deuxième amplificateur opérationnel U2 monté en amplificateur différentiel de gain unitaire ou supérieur à 1, dont l'entrée positive (+) est reliée à un noeud N7 du circuit et dont l'entrée négative (-) est reliée à un noeud N8 du circuit. Le circuit 201 de la figure 4 comprend de plus deux commutateurs K1 et K2. Le commutateur K1 est adapté à connecter le noeud N7 soit au noeud N5 soit au noeud N6, et le commutateur K2 est adapté à connecter le noeud N8 soit au noeud N6 soit au noeud N5. Les commutateurs K1 et K2 ont leurs noeuds de commande reliés à un noeud de sortie N9 de l'amplificateur opérationnel U1. Les commutateurs K1 et K2 présentent de préférence une résistance à l'état passant faible voire négligeable, par exemple de l'ordre de 10 à 50 mΩ. La tension de sortie OUT1 du circuit 201 (référencée par rapport à la masse du circuit, non représentée), est fournie sur un noeud de sortie N10 de l'amplificateur opérationnel U2. Le fonctionnement du circuit 201 de la figure 4 est le suivant. Lorsque le potentiel du noeud N5 est supérieur à celui du noeud N6 (alternance positive de la tension d'entrée IN), la sortie du comparateur U1 est à un premier état, d'où il résulte que le commutateur K1 connecte le noeud N7 au noeud N5 et que le commutateur K2 connecte le noeud N8 au noeud N6. L'alternance positive du signal IN est alors amplifiée par l'amplificateur U2 et reproduite sur la sortie N10 du circuit 201. Lorsque le potentiel du noeud N5 est inférieur à celui du noeud N6 (alternance négative de la tension d'entrée IN), la sortie du comparateur U1 est à un deuxième état, d'où il résulte que le commutateur K1 connecte le noeud N7 au noeud N6 et que le commutateur K2 connecte le noeud N8 au noeud N5. L'alternance négative du signal IN est ainsi redressée par l'intermédiaire des commutateurs K1 et K2, et reproduite sur la sortie N10 du circuit 201 après amplification par l'amplificateur U2.

La figure 5 est un schéma électrique d'un exemple de réalisation du circuit de détection d'enveloppe 203 de la figure 2. Dans cet exemple, le circuit 203 comprend une diode D5 connectée entre des noeuds N11 et N12 du circuit. Le noeud N11 constitue un noeud d'entrée du circuit 203, sur lequel est appliquée la tension d'entrée OUT1, référencée par rapport à un noeud GND d'application d'un potentiel de référence ou masse du circuit. Le circuit 203 de la figure 5 comprend en outre une résistance R1 reliant le noeud N12 à un noeud N13 du circuit, et un condensateur C1 reliant le noeud N13 au noeud GND. Dans cet exemple, le circuit 203 comprend en outre une résistance R2 reliée en parallèle du condensateur C1, entre les noeuds N13 et GND. Le noeud N13 constitue un noeud de sortie du circuit, sur lequel est fournie la tension de sortie OUT2 du circuit. La résistance R1 fixe la vitesse de charge du condensateur C1 sous l'effet des oscillations du signal d'entrée. La résistance R2 est une résistance de décharge du condensateur C1, de valeur significativement plus élevée que la valeur de la résistance R1, par exemple de valeur au moins dix fois supérieure à la valeur de la résistance R1.

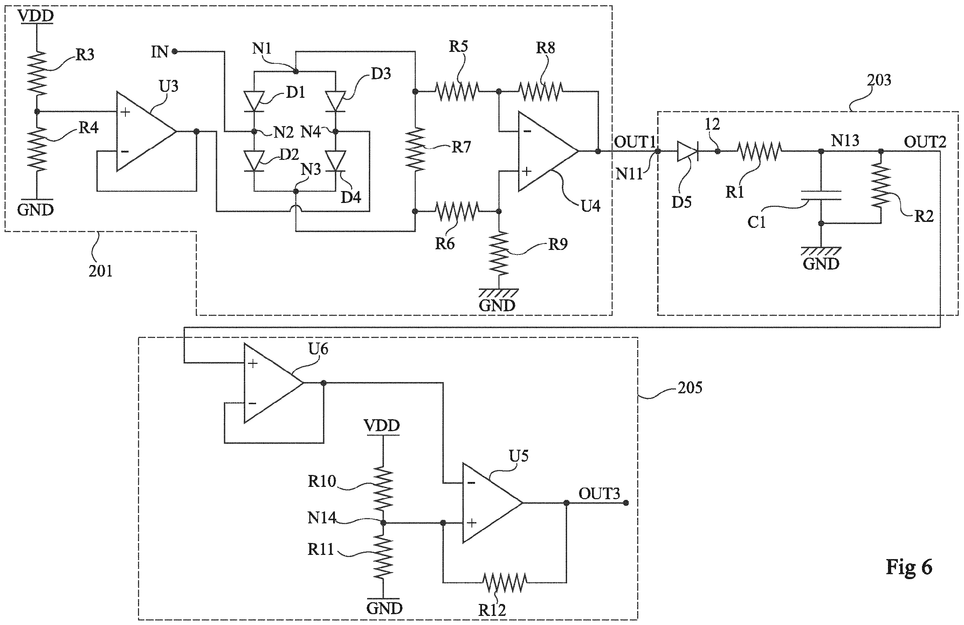

La figure 6 est un schéma électrique d'un exemple de réalisation de l'ensemble du circuit analogique de la figure 2.

Dans cet exemple, le circuit de redressement 201 comprend un pont de diodes identique ou similaire à celui de la figure 3. Comme dans l'exemple de la figure 3, la tension d'entrée IN est appliquée sur le noeud N2 du pont de diodes. Dans l'exemple de la figure 6, un potentiel de référence fixe est appliqué sur le noeud N4 du pont de diodes. Pour cela, le circuit de redressement 201 de la figure 6 comprend un circuit de polarisation comportant un amplificateur opérationnel U3 monté en suiveur de tension, et un pont diviseur de tension résistif comportant des résistances R3 et R4 reliées en série entre un noeud VDD d'application d'un potentiel d'alimentation haut du circuit, par exemple un potentiel compris entre 2 et 10 V, par exemple de l'ordre de 5 V, et un noeud GND d'application d'un potentiel de référence bas du circuit, par exemple la masse. L'entrée positive (+) de l'amplificateur opérationnel U3 est reliée au point milieu entre les résistances R3 et R4, et l'entrée négative (-) de l'amplificateur opérationnel U3 est reliée à sa sortie. La sortie de l'amplificateur opérationnel U3 est reliée au noeud N4. Par ailleurs, dans l'exemple de la figure 6, le circuit de redressement 201 comprend un circuit d'amplification différentielle de la tension de sortie du pont de diodes, de gain unitaire ou supérieur à 1. Ce circuit d'amplification différentielle comprend un amplificateur opérationnel U4 dont l'entrée négative (-) est reliée au noeud N1 par une résistance R5, et dont l'entrée positive (+) est reliée au noeud N3 par une résistance R6, par exemple de même valeur que la résistance R5. Le circuit d'amplification différentielle comprend de plus une résistance R7 reliant le noeud N1 au noeud N3. Le circuit d'amplification différentielle comprend en outre une résistance R8 reliant l'entrée négative (-) de l'amplificateur opérationnel U4 à sa sortie, et une résistance R9 reliant l'entrée positive (+) de l'amplificateur opérationnel U4 au noeud de référence GND du circuit. La tension de sortie OUT1 du circuit 201 (référencée par rapport à la masse du circuit), est fournie sur le noeud de sortie de l'amplificateur opérationnel U4.

Dans l'exemple de la figure 6, le circuit de détection d'enveloppe 203 est identique ou similaire à celui de la figure 5, le noeud d'entrée N11 du circuit 203 étant relié au noeud de sortie de l'amplificateur opérationnel U4 du circuit 201.

Dans cet exemple, le circuit de comparaison 205 comprend un amplificateur opérationnel U5 monté en comparateur à hystérésis, par exemple selon un montage de type bascule de Schmitt. L'entrée négative (-) de l'amplificateur opérationnel U5 est reliée au noeud N13 de sortie du circuit de détection d'enveloppe 203 par l'intermédiaire d'un suiveur de tension ou amplificateur à gain unitaire. Le suiveur de tension comprend un amplificateur opérationnel U6 dont l'entrée positive (+) est reliée au noeud N13 et dont l'entrée négative (-) est reliée à sa sortie. La sortie de l'amplificateur opérationnel U6 est reliée à l'entrée négative (-) de l'amplificateur opérationnel U5. L'entrée positive (+) de l'amplificateur opérationnel U5 est reliée à un noeud N14 d'application d'un potentiel fixe définissant le seuil de déclenchement haut du comparateur. Dans cet exemple, la tension de seuil du comparateur est fournie par un pont diviseur de tension résistif comportant une résistance R10 reliant le noeud N14 au noeud VDD d'alimentation du circuit, et une résistance R11 reliant le noeud N14 au noeud GND de référence ou masse du circuit. Le comparateur 205 comprend en outre une résistance R12 reliant l'entrée positive (+) de l'amplificateur opérationnel U5 à sa sortie. La tension de sortie OUT3 du circuit 205 (référencée par rapport à la masse), est fournie sur le noeud de sortie de l'amplificateur opérationnel U5.

Analyse fréquentielle

Un exemple de méthode d'analyse fréquentielle pouvant être mise en oeuvre par le circuit de traitement numérique 110 de la figure 1 lorsqu'un évènement acoustique remarquable est signalé par le circuit analogique 118 va maintenant être décrit.

L'analyse fréquentielle comprend la conversion du signal temporel 108 fourni par le convertisseur analogique numérique 106 dans le domaine fréquentiel. Pour cela, l'analyse fréquentielle comprend par exemple le calcul d'une transformée de Fourier locale ou STFT (en anglais "Short Time Fourier Transform) sur une fenêtre W[i] de n échantillons consécutifs du signal 108, où n est un entier supérieur à 1, par exemple compris entre 200 et 2000. La densité spectrale de puissance ou DSP dans la fenêtre de traitement W[i] peut ensuite être estimée, par exemple en calculant le module au carré de la STFT normalisé sur l'énergie totale de la fenêtre traitée. Connaissant la ou les bandes de fréquences des ondes acoustiques générées par un arc électrique, il est alors possible de détecter/discriminer efficacement un arc électrique parmi différents types d'événements. A titre d'exemple, l'analyse fréquentielle peut comprendre le calcul de l'énergie du signal 108 dans une bande spectrale caractéristique des arcs électriques, par exemple la bande allant de 80 à 120 kHz ou dans la bande allant de 65 à 90 kHz, et la détection du franchissement éventuel d'un seuil d'énergie dans cette bande. Dans un mode de réalisation préféré, le traitement spectral du signal 108 peut être poursuivi en faisant glisser la fenêtre de traitement W[i] de manière à construire le spectrogramme du signal 108, c'est-à-dire une matrice dans laquelle chaque colonne contient la DSP du signal 108 pour une fenêtre temporelle d'échantillons du signal 108. Le calcul du spectrogramme permet de suivre l'évolution temporelle du spectre du signal 108. L'analyse réalisée est alors une analyse temps-fréquence, présentant l'avantage d'améliorer encore les performances de détection/discrimination des arcs électriques. L'analyse fréquentielle peut notamment comprendre l'analyse de l'évolution temporelle de l'énergie du signal 108 dans une ou plusieurs bandes spectrales spécifiques. Cette analyse peut être réalisée de façon différentielle, par exemple en comparant l'énergie du signal 108 dans une bande spectrale caractéristique des arcs électriques à l'énergie du signal 108 dans une ou plusieurs autres bandes spectrales, par exemple une bande spectrale haute fréquence, par exemple comprise entre 150 et 250 kHz.

La STFT calculée lors de l'analyse fréquentielle peut être définie comme suit :

$$STFT\{x[k]\}(m,\omega) = X[m,\omega] = \sum_{k=-\infty}^{+\infty} x[k] - wind[k-m].e^{-j\omega k}$$

où $X[m,\omega]$ est la STFT, m et $\omega$ sont les variables discrétisées en temps (m) et en fréquence ($\omega$) de la STFT, $x[k]$ est le signal dans le temps, k est le temps discret, et wind[] est la fenêtre glissante utilisée pour choisir et pondérer le sous-ensemble des échantillons sur lequel est estimée la STFT.

Pour un temps m fixé, la DSP calculée lors de l'analyse fréquentielle peut être définie comme suit :

$$P_{X,norm}(\omega) = \frac{|X[\omega]|^2}{\sum_{\omega=0}^{\omega s/2}|X[\omega]|^2}$$

où $X[\omega]$ est la STFT pour un temps m fixé, et où la somme au dénominateur correspond à l'énergie totale du signal contenu dans la fenêtre de calcul dans la bande allant de 0 à $\omega s/2$, avec $\omega s = 2\pi fs$, fs étant la fréquence d'échantillonnage du signal 108.

La DSP $P_{X,norm}(\omega)$ peut être calculée à chaque instant m, de façon à générer le spectrogramme temps-fréquence.

Des modes de réalisation particuliers ont été décrits. Diverses variantes et modifications apparaîtront à l'homme de l'art. En particulier, les modes de réalisation décrits ne se limitent pas à l'exemple de méthode d'analyse fréquentielle du signal 108 décrit ci-dessus. Plus généralement, toute autre méthode d'analyse fréquentielle permettant la détection d'un arc électrique à partir de sa signature acoustique peut être mise en oeuvre par le circuit de traitement numérique 110 suite à la détection d'un évènement remarquable par le circuit analogique 118.

En outre, le procédé de détection d'arc électrique décrit peut comprendre des étapes supplémentaires optionnelles pour améliorer ses performances. A titre d'exemple un prétraitement analogique du signal 104 et/ou un prétraitement numérique du signal 108 peuvent être mis en oeuvre, pour réaliser un filtrage passe-bande du signal acoustique, selon une bande passante incluant les fréquences d'émission typiques des arcs électriques et des chocs mécaniques, de façon à réduire la contribution énergétique du bruit. On notera que l'inclusion dans la bande passante du filtre de prétraitement des fréquences caractéristiques des chocs mécaniques (en plus des fréquences caractéristiques des arcs électriques) est facultative, mais a pour avantage de permettre la mise en oeuvre d'une détection d'arc par analyse différentielle (différence entre l'énergie aux fréquences caractéristiques des arcs et l'énergie aux fréquences caractéristiques des chocs).

Par ailleurs, les modes de réalisation décrits ne se limitent pas aux exemples particuliers de réalisation du circuit analogique 118 décrits en relation avec les figures 3, 4, 5 et 6.

## Revendications

1. Dispositif de détection d'un arc électrique à partir d'un signal analogique de sortie (104) d'au moins un capteur d'ondes acoustiques (102), ce dispositif comprenant :

   un convertisseur analogique-numérique (106) adapté à échantillonner et numériser le signal de sortie (104) du capteur (102) ; et
   un circuit de traitement numérique (110) adapté à mettre en oeuvre une analyse fréquentielle du signal numérique de sortie (108) du convertisseur (106) permettant de détecter la présence éventuelle d'un arc à partir de sa signature acoustique,
   **caractérisé en ce que** le dispositif comprend en outre :

   un circuit analogique (118) de détection d'un dépassement d'un seuil de puissance par le signal de sortie (104) du capteur (102),
   et **en ce que** le circuit de traitement numérique (110) est configuré pour mettre en oeuvre l'analyse fréquentielle uniquement suite à la détection d'un dépassement du seuil par le circuit analogique (118).

2. Dispositif selon la revendication 1, dans lequel le circuit analogique de détection (118) comprend un circuit analogique (205) de comparaison d'une grandeur représentative de l'amplitude du signal analogique de sortie (104) du capteur (102) à un seuil prédéterminé.

**3.** Dispositif selon la revendication 2, dans lequel le circuit analogique de détection (118) comprend en outre un circuit analogique (201) de redressement du signal analogique de sortie (104) du capteur (102), en amont du circuit de comparaison (205).

**4.** Dispositif selon la revendication 3, dans lequel le circuit de redressement (201) comprend un pont de diodes (D1, D2, D3, D4).

**5.** Dispositif selon la revendication 3, dans lequel le circuit de redressement (201) est un circuit actif comprenant au moins un amplificateur opérationnel (U1) et au moins deux interrupteurs commandés (K1, K2).

**6.** Dispositif selon l'une quelconque des revendications 2 à 5, dans lequel le circuit analogique de détection (118) comprend en outre un circuit analogique (203) de détection d'enveloppe en amont du circuit de comparaison (205).

**7.** Dispositif selon l'une quelconque des revendications 1 à 6, dans lequel le convertisseur analogique-numérique (106) est adapté à numériser en permanence, c'est-à-dire même en l'absence de déclenchement de l'analyse fréquentielle par le circuit analogique de détection (118), le signal de sortie (104) du capteur (102).

**8.** Dispositif selon la revendication 7, dans lequel le dispositif de traitement numérique (110) est adapté à mémoriser en permanence, c'est-à-dire même en l'absence de déclenchement de l'analyse fréquentielle par le circuit analogique de détection (118), une pluralité d'échantillons du signal de sortie (108) du convertisseur analogique-numérique (106).

**9.** Dispositif selon l'une quelconque des revendications 1 à 8, dans lequel l'analyse fréquentielle comprend le calcul de la densité spectrale de puissance du signal de sortie (108) du convertisseur (106).

**10.** Dispositif selon la revendication 9, dans lequel l'analyse fréquentielle comprend en outre le calcul d'une grandeur représentative de l'énergie du signal de sortie (108) du convertisseur (106) dans une bande spectrale caractéristique des arcs électriques, et la détection du franchissement éventuel d'un seuil d'énergie dans cette bande.

**11.** Dispositif selon la revendication 10, dans lequel ladite grandeur représentative de l'énergie du signal de sortie (108) du convertisseur (106) dans une première bande spectrale caractéristique des arcs électriques est normalisée par rapport à une grandeur représentative de l'énergie du signal de sortie (108) du convertisseur (106) dans une deuxième bande spectrale.

**12.** Dispositif selon la revendication 11, dans lequel la deuxième bande spectrale est plus large que la première bande spectrale et comprend la première bande spectrale.

**13.** Dispositif selon la revendication 11, dans lequel les première et deuxième bandes spectrales sont disjointes.

**14.** Dispositif selon l'une quelconque des revendications 9 à 13, dans lequel l'analyse temporelle comprend une analyse de l'évolution, en fonction du temps, de ladite densité spectrale de puissance du signal de sortie (108) du convertisseur.

**Patentansprüche**

**1.** Vorrichtung zum Erkennen eines elektrischen Lichtbogens auf der Grundlage eines analogen Ausgangssignals (104) von mindestens einem akustischen Wellensensor (102), wobei die Vorrichtung Folgendes aufweist
einen Analog-Digital-Wandler (106), der in der Lage ist, das Ausgangssignal (104) des Sensors (102) abzutasten und zu digitalisieren; und
eine digitale Verarbeitungsschaltung (110), die in der Lage ist, eine Frequenzbereichsanalyse des digitalen Ausgangssignals (108) des Wandlers (106) zu implementieren, die es ermöglicht, das mögliche Vorhandensein eines Lichtbogens auf der Grundlage seiner akustischen Signatur zu erkennen,
**dadurch gekennzeichnet, dass** die Vorrichtung ferner Folgendes aufweist:

eine analoge Schaltung (118) zum Erfassen des Überschreitens einer Leistungsschwelle durch das Ausgangssignal (104) des Sensors (102),
und dass die digitale Verarbeitungsschaltung (110) so konfiguriert ist, dass sie die Frequenzbereichsanalyse nur bei Erkennung des Überschreitens eines Schwellenwertes durch die analoge Schaltung (118) durchführt.

2.  Vorrichtung nach Anspruch 1, wobei die analoge Erfassungsschaltung (118) eine analoge Schaltung (205) zum Vergleichen einerfür die Amplitude des analogen Ausgangssignals (104) des Sensors (102) repräsentativen Größe mit einem vorbestimmten Schwellenwert aufweist.

3.  Vorrichtung nach Anspruch 2, wobei die analoge Erfassungsschaltung (118) ferner eine der Vergleichsschaltung (205) vorgeschaltete, analoge Schaltung (201) zum Gleichrichten des analogen Ausgangssignals (104) des Sensors (102) aufweist.

4.  Vorrichtung nach Anspruch 3, wobei die Gleichrichterschaltung (201) eine Diodenbrücke (D1, D2, D3, D4) aufweist.

5.  Vorrichtung nach Anspruch 3, wobei die Gleichrichterschaltung (201) eine aktive Schaltung ist, die mindestens einen Operationsverstärker (U1) und mindestens zwei gesteuerte Schalter (K1, K2) aufweist.

6.  Vorrichtung nach einem der Ansprüche 2 bis 5, wobei die analoge Erfassungsschaltung (118) ferner eine der Vergleichsschaltung (205) vorgeschaltete, analoge Hüllkurvenerfassungsschaltung (203) aufweist.

7.  Vorrichtung nach einem der Ansprüche 1 bis 6, wobei der Analog-Digital-Wandler (106) in der Lage ist, das Ausgangssignal (104) des Sensors (102) permanent zu digitalisieren, d.h. auch dann, wenn die Frequenzbereichsanalyse nicht von der analogen Erfassungsschaltung (118) ausgelöst wurde.

8.  Vorrichtung nach Anspruch 7, wobei die digitale Verarbeitungseinrichtung (110) in der Lage ist, eine Vielzahl von Abtastwerten des Ausgangssignals (108) des Analog-Digital-Wandlers (106) permanent zu speichern, d.h. auch dann, wenn die Frequenzbereichsanalyse nicht von der analogen Erfassungsschaltung (118) ausgelöst worden ist.

9.  Vorrichtung nach einem der Ansprüche 1 bis 8, wobei die Frequenzbereichsanalyse das Berechnen der spektralen Leistungsdichte des Ausgangssignals (108) des Wandlers (106) aufweist.

10. Vorrichtung nach Anspruch 9, wobei die Frequenzbereichsanalyse ferner das Berechnen einer Größe, die für die Energie des Ausgangssignals (108) des Wandlers (106) in einem für Lichtbögen charakteristischen Spektralband repräsentativ ist, und das Erfassen des möglichen Überschreitens einer Energieschwelle in diesem Band aufweist.

11. Vorrichtung nach Anspruch 10, wobei die Größe, die für die Energie des Ausgangssignals (108) des Wandlers (106) in einem ersten, für elektrische Lichtbögen charakteristischen Spektralband repräsentativ ist, in Bezug auf eine Größe normalisiert ist, die für die Energie des Ausgangssignals (108) des Wandlers (106) in einem zweiten Spektralband repräsentativ ist.

12. Vorrichtung nach Anspruch 11, wobei das zweite Spektralband breiter als das erste Spektralband ist und das erste Spektralband aufweist.

13. Vorrichtung nach Anspruch 11, wobei das erste und das zweite Spektralband getrennt voneinander sind.

14. Vorrichtung nach einem der Ansprüche 9 bis 13, wobei die Zeitbereichsanalyse eine Analyse der zeitlichen Veränderung der spektralen Leistungsdichte des Ausgangssignals (108) des Wandlers aufweist.


**Claims**

1.  A device for detecting an electric arc based on an analog output signal (104) of at least one acoustic wave sensor (102), this device comprising:

    an analog-to-digital converter (106) capable of sampling and digitizing the output signal (104) of the sensor (102); and
    a digital processing circuit (110) capable of implementing a frequency domain analysis of the digital output signal (108) of the converter (106) enabling to detect the possible presence of an arc based on its acoustic signature,
    **characterized in that** the device further comprises:

an analog circuit (118) for detecting the exceeding of a power threshold by the output signal (104) of the sensor (102),

and **in that** the digital processing circuit (110) is configured to implement the frequency domain analysis only on detection of the exceeding of a threshold by the analog circuit (118) .

2. The device of claim 1, wherein the analog detection circuit (118) comprises an analog circuit (205) for comparing a quantity representative of the amplitude of the analog output signal (104) of the sensor (102) with a predetermined threshold.

3. The device of claim 2, wherein the analog detection circuit (118) further comprises an analog circuit (201) for rectifying the analog output signal (104) of the sensor (102), upstream of the comparison circuit (205).

4. The device of claim 3, wherein the rectifying circuit (201) comprises a diode bridge (D1, D2, D3, D4).

5. The device of claim 3, wherein the rectifying circuit (201) is an active circuit comprising at least one operational amplifier (U1) and at least two controlled switches (K1, K2).

6. The device of any of claims 2 to 5, wherein the analog detection circuit (118) further comprises an analog envelope detection circuit (203) upstream of the comparison circuit (205).

7. The device of any of claims 1 to 6, wherein the analog-to-digital converter (106) is capable of permanently digitizing, that is, even when the frequency domain analysis has not been triggered by the analog detection circuit (118), the output signal (104) of the sensor (102).

8. The device of claim 7, wherein the digital processing device (110) is capable of permanently storing, that is, even when the frequency domain analysis has not been triggered by the analog detection circuit (118), a plurality of samples of the output signal (108) of the analog-to-digital converter (106).

9. The device of any of claims 1 to 8, wherein the frequency domain analysis comprises calculating the spectral power density of the output signal (108) of the converter (106).

10. The device of claim 9, wherein the frequency domain analysis further comprises calculating a quantity representative of the energy of the output signal (108) of the converter (106) in a spectral band characteristic of electric arcs, and detecting the possible crossing of an energy threshold in this band.

11. The device of claim 10, wherein said quantity representative of the energy of the output signal (108) of the converter (106) in a first spectral band characteristic of electric arcs is normalized with respect to a quantity representative of the energy of the output signal (108) of the converter (106) in a second spectral band.

12. The device of claim 11, wherein the second spectral band is wider than the first spectral band and comprises the first spectral band.

13. The device of claim 11, wherein the first and second spectral bands are separate.

14. The device of any of claims 9 to 13, wherein the time domain analysis comprises an analysis of the time variation of said spectral power density of the output signal (108) of the converter.

Fig 1

Fig 2

Fig 3

Fig 4

Fig 5

Fig 6

EP 3 264 116 B1

**EP 3 264 116 B1**

## RÉFÉRENCES CITÉES DANS LA DESCRIPTION

**Documents brevets cités dans la description**

- FR 3015045

- US 2006164097 A